Europäisches Patentamt

European Patent Office

Office européen des brevets

(11) Veröffentlichungsnummer: **0 473 817 A1**

# EUROPÄISCHE PATENTANMELDUNG

(21) Anmeldenummer: **90116915.1**

(51) Int. Cl.5: **H05K 13/04**

(22) Anmeldetag: **03.09.90**

(43) Veröffentlichungstag der Anmeldung:
**11.03.92 Patentblatt 92/11**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Rombauer, Theodore, Dipl.-Ing.**
**Backerstrasse 8**
**W-8000 München 60(DE)**
Erfinder: **Raschke, Josef**
**Sommerhausstrasse 11**
**W-8011 Gelting(DE)**

(54) **Vorrichtung zum Aufbringen von Lötflussmittel auf Leiterplatten.**

(57) Am verfahrbaren Kopf einer Bestück- oder Lötvorrichtung wird eine Sprühvorrichtung (Sv) lösbar befestigt, mit welcher vorgegebene Lötstellen auf einer Leiterplatte angefahren und mit Lötflußmittel (L) besprüht werden. Die Sprühvorrichtung (Sv) umfaßt einen Vorratsbehälter (V) zur Aufnahme des flüssigen Lötflußmittels (L) und eine aus dem Vorratsbehälter (V) gespeiste Sprühdüse (Sd), aus welcher das Lötflußmittel (L) vorzugsweise mit Hilfe von Druckluft (D11) versprüht wird. Eine zentrale Öffnung (O) der Sprühvorrichtung ermöglicht den Durchtritt einer am Kopf für die Bestückung der Leiterplatte mit Bauelementen angeordneten Saugpipette.

Fig. 1

EP 0 473 817 A1

Lötvorrichtungen mit zwei parallel einander gegenüberliegenden Bügelelektroden oder mit vier paarweise einander gegenüberliegenden Bügelelektroden werden insbesondere für das Auflöten hochpoliger elektronischer Bauelemente wie Mikropacks, Flatpacks und dergleichen eingesetzt, wobei die Widerstandserwärmung der Bügelelektroden in der Regel durch Stromimpulse vorgenommen wird.

Für die automatische Bestückung von Leiterplatten mit SMD-Bauelementen nach dem Pick and Place Prinzip, dem Collect and Place Prinzip oder mittels eines Chip-Shooters werden relativ zur Leiterplatte verfahrbare Bestückköpfe verwendet, welche die Bauelemente mit Hilfe von Saugpipetten aus den Zuführmodulen aufnehmen, gegebenenfalls zentrieren und in die richtige Einbaulage drehen und in der vorgegebenen Bestückposition auf der Leiterplatte absetzen.

Es ist auch bereits bekannt, Lötvorrichtungen mit zwei oder vier Bügelelektroden an einem verfahrbaren Kopf anzubringen, der zusätzlich noch mit einer Saugpipette ausgerüstet ist (DE-Z Feinwerktechnik & Meßtechnik 96, 1988, Heft 9, S. 387 - 389). Die Saugpipette entnimmt aus einem Zuführmodul ein genau positioniertes Bauelement und hält es dann mit dieser Positionier-Genauigkeit exakt unter den Bügelelektroden der Lötvorrichtung. Das Bauelement wird dann in der vorgegebenen Bestückposition auf die Lötstellen der Leiterplatten abgesenkt und durch die Saugpipette mit einer geringen Kraft auf die Leiterplatte gepreßt und auch in dieser Position während des Lötvorganges gehalten.

Auf die Lötstellen von Leiterplatten müssen vor dem Positionieren der aufzulötenden Bauelemente selektiv Lötflußmittel aufgebracht werden, welche dann beim Lötvorgang eine Reduktion der Oxide zwischen den zu verbindenen Teilen bewirken. Das Aufbringen des Lötflußmittels wird dabei mit Kanülen oder Filzstiften vorgenommen, welche auf die entsprechenden Lötstellen einer Leiterplatte abgesenkt werden. Ein Aufbringen des Lötflußmittels durch Stempeln ist ebenfalls bekannt.

Der im Anspruch 1 angegebenen Erfindung liegt das Problem zugrunde, den Aufwand beim Aufbringen von Lötflußmittel auf die Lötstellen von nachfolgend mit Bauelementen zu bestückenden Leiterplatten zu verringern und die Vorraussetzungen für eine Verkettung in flexiblen Linien für die automatische Leiterplattenbestückung zu schaffen.

Die mit der Erfindung erzielten Vorteile bestehen insbesondere darin, daß der verfahrbare Kopf der Lötvorrichtung nach dem Abkoppeln des Lötbügelhalters ohne zusätzlichen Aufwand auch für das programmierbare Aufbringen des Lötflußmittels herangezogen werden kann. Die Vorraussetzungen hierzu werden durch die Ausrüstung der an den Kopf angekoppelten Sprühvorrichtungen mit einer Sprühdüse und einem Vorratsbehälter für flüssiges Lötflußmittel geschaffen.

Vorteilhafte Ausgestaltungen der Erfindung sind in den Ansprüchen 2 bis 12 angegeben.

Die Weiterbildung nach Anspruch 2 ermöglicht eine Ankoppelung der Sprühvorrichtung auch dann, wenn an dem Kopf eine Saugpipette befestigt ist. Im Hinblick auf den durch die Mitte der Saugpipette definierten Verfahrbereich des Kopfes sollte die Sprühdüse dann möglichst dicht neben der Saugpipette angeordnet sein.

Die Ausgestaltung nach Anspruch 3 bietet die Möglichkeit, die beim Aufsprühen des flüssigen Lötflußmittels entstehenden Lösemitteldämpfe unmittelbar am Ort ihrer Entstehung abzusaugen.

Die Weiterbildung nach Anspruch 4 sieht ein Versprühen des Lötflußmittels mit Hilfe von Druckluft vor. Wird dann die Sprühdüse gemäß Anspruch 5 während des Einsatzes der Sprühvorrichtung ständig mit Druckluft beaufschlagt, so können hierdurch Ablagerungen und Verunreinigungen im Bereich der Sprühdüse und der zugeordneten Regelorgane mit Sicherheit vermieden werden.

Die Weiterbildung gemäß Anspruch 6 sieht für eine exakte und robuste Regelung des zugeführten Lötflußmittels den Einsatz eines Nadelventils vor. Hierbei ist es dann zweckmäßig gemäß Anspruch 7 die Betätigung des Nadelventils pneumatisch über einen zweiten Druckluftanschluß der Sprühvorrichtung vorzunehmen.

Gemäß Anspruch 8 kann die Funktionssicherheit der erfindungsgemäßen Vorrichtung durch den Einsatz eines Sensors für die Überwachung des Sprühvorganges wesentlich erhöht werden.

Die Weiterbildung gemäß Anspruch 9 sieht für die Überwachung des Sprühvorganges den Einsatz eines Thermoelements vor. Hierbei wird die Tatsache ausgenützt, daß beim Sprühvorgang durch die Verdunstung des im Lötflußmittel enthaltenen Lösemittels, meist eines Alkohols, lokal eine Abkühlung in der Größenordnung von etwa 10°C auftritt. Gemäß Anspruch 10 kann dann auch durch den Einsatz eines zweiten Thermoelements das Überwachungsprinzip von der Umgebungstemperatur unabhängig gemacht werden.

Die Weiterbildung gemäß Anspruch 11 sieht eine besonders günstige und platzsparende Unterbringung des Nadelventils vor. Das Nadelventil nimmt hierbei in dem verfahrbaren Kopf den Raum ein, der bei der Ankoppelung einer Lötvorrichtung durch einen vierten Haltestift dieser Lötvorrichtung eingenommen wird.

Gemäß Anspruch 12 wird einer der Haltestifte gleichzeitig als schraubbarer Verschluß des Vorratsbehälters verwendet, d. h. der Aufwand für einen separaten Verschluß entfällt.

Ausführungsbeispiele der Erfindung sind in der Zeichnung dargestellt und werden im folgenden näher beschrieben.

Es zeigen

Fig. 1    einen Schnitt durch eine erfindungsgemäße Sprühvorrichtung,

Fig. 2    eine Draufsicht auf die Oberseite der Sprühvorrichtung gemäß Fig. 1,

Fig. 3    eine teilweise aufgebrochen dargestellte Seitenansicht einer mit einem Sensor für die Überwachung der Sprühtätigkeit ausgerüsteten Sprühvorrichtung und

Fig. 4    eine Draufsicht auf die Unterseite der Sprühvorrichtung gemäß Fig. 3.

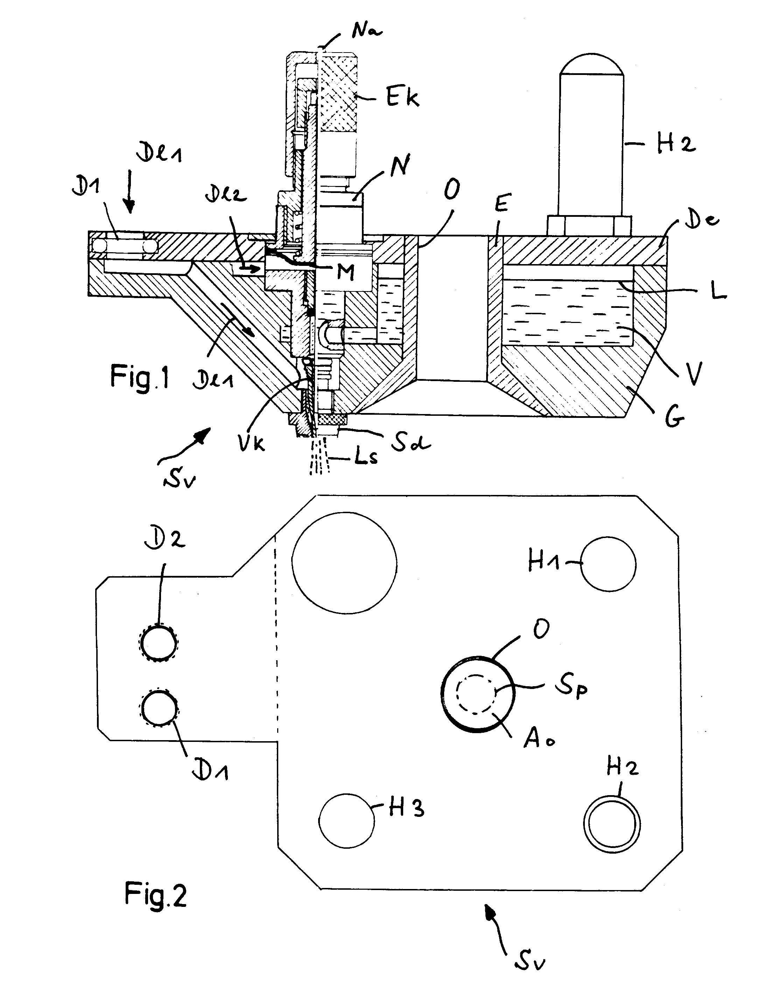

Das in den Fig. 1 und 2 dargestellte Ausführungsbeispiel zeigt eine insgesamt mit Sv bezeichnete Sprühvorrichtung, welche mit zylindrischen Haltestiften H1, H2 und H3 in dem verfahrbaren Kopf einer Bügellötvorrichtung aufgenommen wird. Dieser in der Zeichnung nicht näher dargestellte, in x-, y- und z-Richtung verfahrbare Kopf ist Mit einer Saugpipette Sp ausgerüstet, deren Kontur in Fig. 2 durch eine strichpunktierte Linie angedeutet ist. Um Platz für diese Saugpipette Sp zu schaffen, besitzt die Sprühvorrichtung Sv eine zentrale Öffnung O, durch welche die Saugpipette Sp unter Bildung einer ringförmigen Absaugöffnung Ao hindurchtritt.

In dem mit G bezeichneten Grundkörper der Sprühvorrichtung Sv1 befindet sich ein Hohlraum, welcher einen Vorratsbehälter V zur Aufnahme von flüssigem Lötflußmittel L bildet. Die bereits erwähnte Öffnung O wird durch einen den Vorratsbehälter V durchdringenden zylindrischen Einsatz E gebildet, während der obere Abschluß des Vorratsbehälters V durch einen Deckel De erfolgt. Zum Nachfüllen des Vorratsbehälters V mit Lötflußmittel L wird der bereits erwähnte Haltestift H2 aus dem Deckel De herausgeschraubt.

Aus dem Vorratsbehälter V wird das Lötflußmittel L einer Sprühdüse Sd zugeführt und dort mit Hilfe von Druckluft D11 verstäubt. Die Zufuhr dieser Druckluft D11 mit einem Druck von beispielsweise 2,5 bar erfolgt über einen ersten Druckluftanschluß D1 im Deckel De. Ein zweiter Druckluftanschluß D2 im Deckel De dient zur pneumatischen Betätigung eines insgesamt mit N bezeichneten Nadelventils, welches die Zufuhr des Lötflußmittels L zur Sprühdüse Sd steuert. Bei diesem Nadelventil N handelsüblicher Bauart sind die Nadel mit Na, der Ventilkörper mit Vk, eine Membran mit M und eine gerändelte Einstellkappe mit Ek bezeichnet. Bei Beaufschlagung des zweiten Druckluftanschlusses D2 mit Druckluft D12 wird die Membran M und damit auch die Nadel Na angehoben, so daß zwischen Nadel Na und Ventilkörper Vk Lötflußmittel L austreten kann und in der Sprühdüse Sd durch die Druckluft D11 als Lötflußmittelstrahl Ls verstäubt wird. Die Sprühmenge kann dabei durch die Einstellkappe Ek manuell eingestellt werden, während die Sprühdauer durch die Dauer der Beaufschlagung mit Druckluft D12 bestimmt wird.

Beim Betrieb der in den Fig. 1 und 2 dargestellten Sprühvorrichtung Sv werden mit dem bereits erwähnten Kopf der Bügellötvorrichtung die Lötstellen auf Leiterplatten nacheinander derart angefahren, daß sich die Sprühdüse direkt über den Lötstellen befindet und das Lötflußmittel L durch Betätigung des Nadelventils N in Form eines Lötflußmittelstrahls Ls aufgebracht werden kann. Die beim Versprühen des Lötflußmittels L entstehenden Lösemitteldämpfe werden über die bereits erwähnte ringförmige Absaugöffnung Ao und die in dem Kopf vorhandene Absaugeinrichtung abgeführt. Durch das Aufstäuben mit Luft verdampft das in dem Lötflußmittel L enthaltene Lösemittel auf dem Weg zur Leiterplatte zumindest weitgehend.

Die Sprühdüse Sd und das Nadelventil N sind im Raster der Haltestift H1, H2 und H3 angeordnet. Durch diese Maßnahme findet der über den Deckel De hinausragende Bereich des Nadelventils N in einer Aufnahmebuchse des verfahrbaren Kopfes Platz, die sonst zur Aufnahme eines vierten Haltestiftes der an dem Kopf ebenfalls zu befestigenden Bügellötvorrichtung dient.

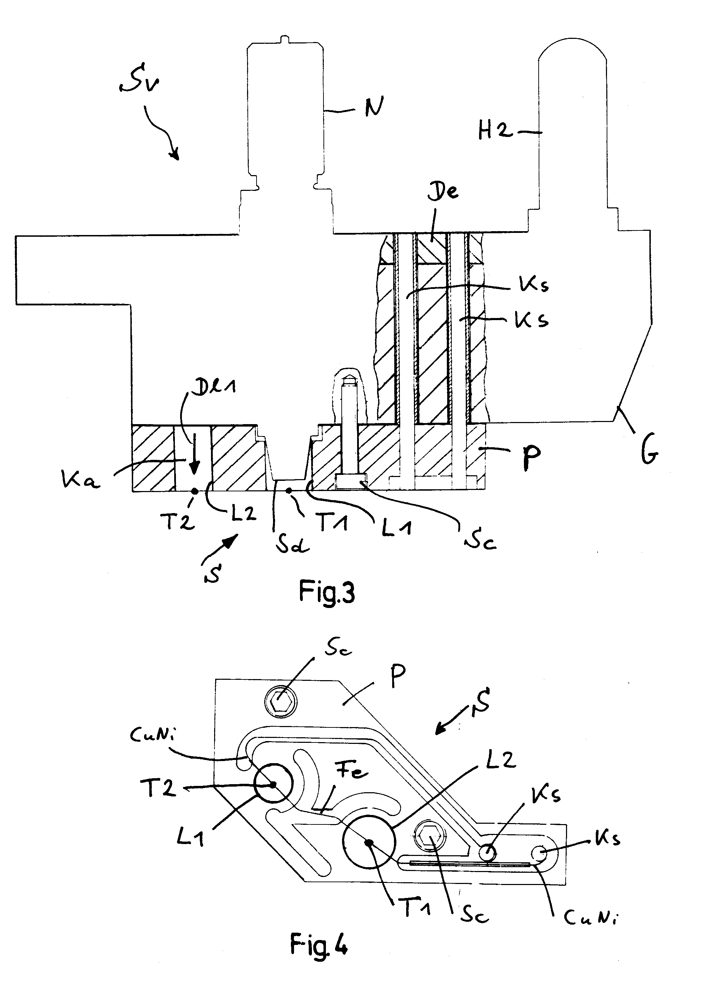

Die Fig. 3 und 4 zeigen eine Variante der in den Fig. 1 und 2 dargestellten Vorrichtung, bei welcher zur Überwachung der Sprühdüse Sd ein insgesamt mit S bezeichneter Sensor vorgesehen ist. Dieser Sensor S umfaßt eine mit Löchern L1 und L2 versehene Platte P, die aus einem elektrisch isolierenden Werkstoff besteht und mit Hilfe von zwei Schrauben Sc an der Unterseite des Grundkörpers G befestigt ist. Das Loch L1 ist dabei fluchtend zur Sprühdüse Sd ausgerichtet, während das Loch L2 einen in nicht näher erkennbarer Weise mit dem Druckluftanschluß D1 (vgl. Fig. 1 und 2) verbundenen Kanal Ka bildet. Im Bereich des Austrittsquerschnittes des Loches L1 ist ein erstes Thermoelement T1 angeordnet, während im Bereich des Austrittsquerschnittes des Loches L2 ein zweites Thermoelement T2 angeordnet ist. Die äußeren, zu Kontaktstiften Ks führenden Leitungen der Thermoelemente T1 und T2 bestehen gemäß Fig. 4 aus CuNi, während die Verbindungsleitung zwischen den Thermoelementen T1 und T2 aus Fe besteht. Die Kontaktstifte Ks sind durch den Grundkörper G und den Deckel De elektrisch isoliert hindurchgeführt, so daß ihre oberen Enden beim Anbringen der Sprühvorrichtung Sv an dem verfahrbaren Kopf mit entsprechenden Kontakten des Kopfes verbunden werden.

Strömt aus den Löchern L1 und L2 jeweils nur reine Druckluft D11 (vgl. Fig. 1) gleicher Temperatur aus, so liegt zwischen den beiden Kontaktstiften Ks keine Thermospannung an. Tritt aber aus der Sprühdüse Sd Druckluft D11 und Lötflußmittel L aus, so bewirkt die Verdunstung des im Lötflußmittel L enthaltenen Lösemittels eine Abkühlung im Bereich des ersten Thermoelements T1 und damit die Erzeugung einer Thermospannung zwischen den Kontaktstiften Ks. Diese Thermospannung ist dann unabhängig von der jeweiligen Raumtemperatur ein Maß für die Temperaturdifferenz zwischen der aus dem Loch L2 austretenden Druckluft D11 und dem aus dem Loch L1 austretenden Gemisch aus Druckluft D11 und Lötflußmittel L. Liegt also zwischen den Kontaktstiften Ks eine Thermospannung an, ist damit der Nachweis erbracht, daß vorher auch tatsächlich auch Lötflußmittel L versprüht worden ist.

**Patentansprüche**

1. Vorrichtung zum Aufbringen von Lötflußmittel (L) auf die Lötstellen von nachfolgend mit Bauelementen zu bestückenden Leiterplatten, **gekennzeichnet durch**,
   - eine an dem verfahrbaren Kopf einer Bestück- oder Lötvorrichtung lösbar anbringbare Sprühvorrichtung (Sv) mit
   - einem Vorratsbehälter (V) zur Aufnahme von flüssigem Lötflußmittel (L) und
   - eine aus dem Vorratsbehälter (V) gespeiste Sprühdüse (Sd) zum Aufsprühen des Lötflußmittels (L) auf die mit dem Kopf anfahrbaren Lötstellen.

2. Vorrichtung nach Anspruch 1, **dadurch gekennzeichnet**, daß die Sprühvorrichtung (Sv) eine zentrale Öffnung (O) für den Durchtritt einer an dem Kopf befestigten Saugpipette (Sp) aufweist.

3. Vorrichtung nach Anspruch 2, **gekennzeichnet durch** eine zwischen Öffnung (O) und Saugpipette (Sp) gebildete ringförmige Absaugöffnung (Ao) für Lösemitteldämpfe.

4. Vorrichtung nach einem der vorhergehenden Ansprüche, **dadurch gekennzeichnet**, daß die Sprühvorrichtung (Sv) einen Druckluftanschluß (D1) für die Zufuhr von Druckluft (D11) zu der Sprühdüse (Sd) aufweist.

5. Vorrichtung nach Anspruch 4, **dadurch gekennzeichnet**, daß die Sprühdüse (Sd) während des Einsatzes der Sprühvorrichtung (Sv) ständig mit Druckluft (D11) beaufschlagt ist.

6. Vorrichtung nach einem der vorhergehenden Ansprüche, **dadurch gekennzeichnet**,

daß die Zufuhr von Lötflußmittel (L) zur Sprühdüse (Sd) durch ein Nadelventil (N) regelbar ist.

7. Vorrichtung nach Anspruch 6, **dadurch gekennzeichnet**, daß das Nadelventil (N) über einen zweiten Druckluftanschluß (D2) der Sprühvorrichtung (Sv) pneumatisch betätigbar ist.

8. Vorrichtung nach einem der vorhergehenden Ansprüche, **dadurch gekennzeichnet**, daß das Versprühen von Lötflußmittel (L) aus der Sprühdüse (Sd) durch einen Sensor (S) überwachbar ist.

9. Vorrichtung nach Anspruch 8, **dadurch gekennzeichnet**, daß der Sensor (S) ein im Austrittsbereich der Sprühdüse (Sd) angeordnetes Thermoelement (T1) umfaßt.

10. Vorrichtung nach den Ansprüchen 4 und 9, **dadurch gekennzeichnet**, daß der Sensor (S) ein zweites Thermoelement (T2) umfaßt, das über einen separaten Kanal (Ka) und den Druckluftanschluß (D1) mit Druckluft (D11) beaufschlagbar ist.

11. Vorrichtung nach einem der Ansprüche 6 bis 10, **dadurch gekennzeichnet**, daß die Sprühvorrichtung (Sv) mit Hilfe von drei Haltestiften (H1, H2, H3) lösbar im Kopf befestigt ist und daß das Nadelventil (N) im Raster der Haltestifte (H1, H2, H3) angeordnet ist.

12. Vorrichtung nach Anspruch 11, **dadurch gekennzeichnet**, daß ein Haltestift (H2) als schraubbarer Verschluß des Vorratsbehälters (V) ausgebildet ist.

Fig.1

Fig.2

Fig.3

Fig. 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 274 568 (MADISION-KIPP)<br>* Spalte 2, Zeile 15 - Spalte 3, Zeile 4; Figur 2 *<br>– – – | 1,4,5 | H 05 K 13/04 |
| A | EP-A-0 324 441 (MARTIN)<br>* Spalte 1, Zeilen 17-36; Spalte 6, Zeilen 30-52; Figuren 2,3 *<br>– – – | 1,6,7 | |
| A | DE-A-3 427 004 (HOHNERLEIN)<br>* Seite 4, Zeilen 9-17 *<br>– – – – – | 1,3 | |

RECHERCHIERTE SACHGEBIETE (Int. Cl.5)

H 05 K
H 01 L
B 23 K
B 05 B

Der vorliegende Recherchenbericht wurde für alle Patentansprüche erstellt

| Recherchenort | Abschlußdatum der Recherche | Prüfer |
|---|---|---|
| Den Haag | 29 April 91 | BOLDER G.J.A. |